# EUROPÄISCHE PATENTSCHRIFT

(11) **EP 0 922 298 B1**
(45) Veröffentlichungstag und Bekanntmachung des Hinweises auf die Patenterteilung: **15.05.2002**
(21) Anmeldenummer: 97942892.7
(22) Anmeldetag: 28.08.1997
(51) Int. Cl.: H01L 21/768, H01L 21/316

(54) **VERFAHREN ZUM PLANARISIEREN EINER SUBSTRATOBERFLÄCHE**
PROCESS FOR SMOOTHENING A SUBSTRATE SURFACE
PROCEDE POUR RENDRE PLANE UNE SURFACE DE SUBSTRAT

(30) Priorität: 28.08.1996 DE 19634841
(43) Veröffentlichungstag der Anmeldung: 16.06.1999
(73) Patentinhaber: Infineon Technologies AG, 81669 München (DE); FRAUNHOFER-GESELLSCHAFT ZUR FÖRDERUNG DER ANGEWANDTEN FORSCHUNG E.V., 80636 München (DE)
(72) Erfinder: GRASSL, Thomas, D-95354 Freising (DE); GABRIC, Zvonimir, D-85604 Zorneding (DE); SPINDLER, Oswald, D-85591 Vaterstetten (DE)
(74) Vertreter: Kindermann, Peter, Dipl.-Ing.
(86) Internationale Anmeldenummer: EP9704697
(87) Internationale Veröffentlichungsnummer: WO9809326

(56) Entgegenhaltungen:
- DE-A- 4 012 901
- HOMMA T ET AL: "A FULLY PLANARIZED MULTILEVEL INTERCONNECTION TECHNOLOGY USING SEMI-SELECTIVE TETRAETHOXYSILANE-OZONE CHEMICAL VAPOR DEPOSITION AT ATMOSPHERIC PRESSURE" JOURNAL OF THE ELECTROCHEMICAL SOCIETY, Bd. 140, Nr. 12, 1.Dezember 1993, Seiten 3591-3599, XP000430012
- PATENT ABSTRACTS OF JAPAN vol. 095, no. 008, 29.September 1995 & JP 07 115134 A (MATSUSHITA ELECTRON CORP), 2.Mai 1995,

## Beschreibung

Die vorliegende Erfindung bezieht sich auf ein Verfahren zum Planarisieren einer Substratoberfläche und insbesondere auf ein Verfahren zum Planarisieren einer Substratoberfläche, die Höhenunterschiede aufweist, die von metallischen Strukturen hervorgerufen sind, durch das Abscheiden von SiO₂ mittels eines TEOS-Prozesses.

Bei der Erzeugung hochintegrierter Schaltkreise treten innerhalb der Verdrahtungsebenen starke Höhenunterschiede auf, die durch auf den Substraten angeordnete Leiterstrukturen hervorgerufen sind. Diese extremen Topographien können zu Schwierigkeiten bei Photolithographieprozessen führen, da bei denselben ein direkter Zusammenhang zwischen Auflösung und Tiefenschärfe besteht. Ferner wird es durch eine zunehmende Integrationsdichte bewirkte, abnehmende Leiterbahnabstände und zunehmende Höhen-zu-Weiten-Verhältnisse zwischen den Leiterbahnen immer schwieriger, die Zwischenräume zwischen den Leiterbahnen mit dielektrischen Schichten lunkerfrei aufzufüllen.

Zur Planarisierung derartiger mit Unebenheiten versehener Substratoberflächen ist gemäß dem Stand der Technik das Aufschleudern einer Hilfsschicht (sacrificial layer) auf die mit Unebenheiten versehene Substratoberfläche, d.h. das topographisch ungünstige Dielektrikum, bekannt. Durch das Zusammenwirken der Viskosität und der Oberflächenspannung dieser flüssig aufgetragenen Schicht bildet sich eine abhängig von dem verwendeten Material mehr oder weniger planare Oberfläche aus. Diese Oberfläche wird dann durch ein isotropes Rückätzverfahren auf das darunterliegende Dielektrikum übertragen, wobei die Hilfsschicht ganz oder zum großen Teil abgeätzt, d.h. geopfert, wird.

Bei einem alternativen bekannten Verfahren verbleibt das planarisierende Material nach dem Aufschleudern desselben auf dem Substrat. Dieses Verfahren ist als Leaveon-Verfahren bekannt. Ein weiteres bekanntes Verfahren zum Ausgleich von Topographieunterschieden verwendet ein chemisch-mechanisches Polieren der Dielektrikumsoberfläche zur Planarisierung. Bei diesem Verfahren werden die erhabenen Stellen der Oberfläche durch einen chemisch unterstützten, mechanischen Abtrag eingeebnet. Dieses Verfahren ist als CMP-Verfahren bekannt (CMP = chemical mechanical polish).

Ein weiteres bekanntes Verfahren zum Planarisieren von Unebenheiten einer Substratoberfläche beruht auf einer O₃-aktivierten selektiven Abscheidung von SiO₂ aus Tetraethylortosilikat (TEOS). Dieses Verfahren beruht darauf, daß die oben genannte Abscheidung auf unterschiedlich gearteten Oberflächen unterschiedliche Abscheideraten induziert, d.h. selektiv ist. Um eine Planarisierung zu bewirken, wird die Schichtkombination derart gewählt, daß auf topographisch tiefer angeordneten Horizontalflächen die Abscheiderate höher ist als auf topographisch erhabenen Flächen. Nach einer von dem Abscheideverhältnis auf den verschiedenen Flächen abhängigen Zeit stellt sich ein Niveauausgleich, d.h. eine Planarisierung, ein.

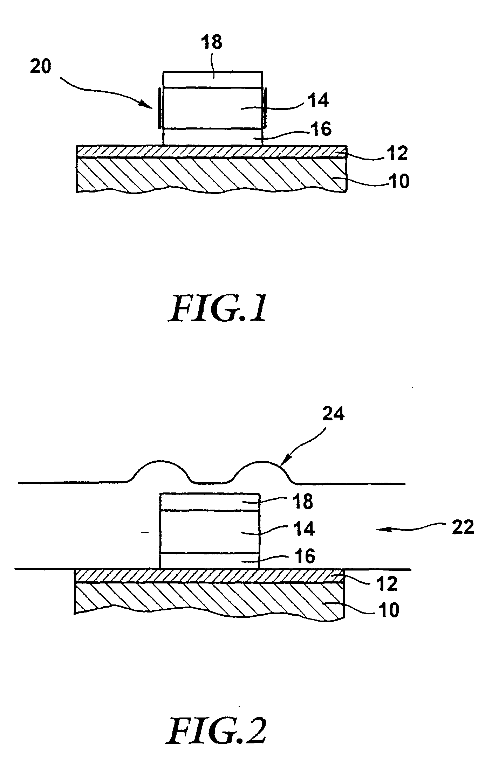

In Fig. 1 ist ein üblicherweise vorzugsweise verwendeter Schichtaufbau dargestellt. Als Substrat dient beispielsweise ein Siliziumsubstrat 10, auf das eine SiO₂-Schicht 12 über den IC-Bauelementen aufgebracht ist. Auf das Substrat, das aus der Siliziumschicht 10 und der SiO₂-Schicht 12 besteht, ist ein metallischer Leiter 14 aufgebracht. Dabei kann zwischen dem metallischen Leiter 14 und der SiO₂-Schicht 12 eine Zwischenschicht 16, die beispielsweise aus Ti oder TiN besteht, angeordnet sein. Auf den metallischen Leiter 14, der vorzugsweise aus Aluminium, Kupfer oder einer Legierung derselben, beispielsweise AlSiCu, besteht, ist eine TiN-Schicht 18 aufgebracht. Die Seitenflanken des metallischen Leiters 14 sind, wenn derselbe aus Aluminium besteht, in erster Näherung als ein mit Al₂O₃ 20 bedecktes Aluminium anzusehen.

Ein Schichtaufbau der oben beschriebenen Art wird dann einem TEOS-Prozeß unterworfen, durch den eine SiO₂-Schicht 22, wie in Fig. 2 dargestellt ist, auf der Substratoberfläche abgeschieden wird. Der in der Technik bekannte TEOS-Prozeß weist dabei auf der Oberfläche der SiO₂-Schicht 12 und der Oberfläche der TiN-Abdeckung 18 des metallischen Leiters 14 unterschiedliche Abscheidungsraten auf. D.h., daß auf der SiO₂-Schicht 12 eine schnellere Abscheidung stattfindet, während auf der TiN-Schicht 18 eine langsamere Abscheidung stattfindet.

Bei der oben genannten Abscheidung entspricht die Aufwachsrate an den Seitenflächen des metallischen Leiters 14, d.h. auf dem Aluminium bzw. dem Al₂O₃ der Abscheidungsrate auf der SiO₂-Schicht 12. Dadurch ergeben sich bei einer selektiven Abscheidung mittels des TEOS-Prozesses an den Kanten des metallischen Leiters 14 die in Fig. 2 bei 24 dargestellten Ohren, die die nach dem Abscheidungsverfahren erhaltene Planarität der Substratoberfläche stören.

Als Beispiele des Standes der Technik könnten der Artikel von T. Homma et al., Journal of the Electrochemical society, Band 140, Nr. 12, 1. Dezember 1993 und die japanische Patentschrift JP-A-07 115 134 zitiert werden.

Ausgehend von dem oben genannten Stand der Technik liegt der vorliegenden Erfindung die Aufgabe zugrunde, ein Verfahren zur Planarisierung einer Substratoberfläche, die Höhenunterschiede aufweist, die von metallischen Strukturen hervorgerufen sind, mittels eines TEOS-Prozesses zu schaffen, das gegenüber bekannten Verfahren eine verbesserte Planarität bewirkt.

Diese Aufgabe wird durch ein Verfahren gemäß Anspruch 1 gelöst.

Die vorliegende Erfindung schafft ein Verfahren zur Planarisierung einer Substratoberfläche, die Höhenunterschiede aufweist, die von metallischen Strukturen hervorgerufen sind, mit folgenden Schritten: Aufbringen einer metallischen Titanverbindungsschicht auf die Oberfläche und die Seitenflächen der metallischen Strukturen; O₃-aktiviertes Abscheiden von SiO₂ oder von SiOF aus einer Siliziumvorstufe auf der mit den metallischen Strukturen versehenen Substratoberfläche.

Gemäß einer bevorzugten Ausführungsform schafft die vorliegende Erfindung ein Verfahren zur Planarisierung einer Substratoberfläche, die Höhenunterschiede aufweist, die von metallischen Strukturen hervorgerufen sind, bei dem eine TiN-Schicht auf die Oberfläche und die Seitenflächen der metallischen Leiterstrukturen aufgebracht wird. Danach erfolgt ein O₃-aktiviertes Abscheiden von SiO₂ aus Tetraethylortosilikat (TEOS) auf der mit den metallischen Leiterstrukturen versehenen Substratoberfläche.

Besonders geeignet ist das erfindungsgemäße Verfahren zur Verwendung mit einem Siliziumsubstrat, das eine SiO₂-Schicht aufweist. Die auf dem Substrat angeordnete Leiterbahn wird beispielsweise mittels Plasmadampfabscheidungsverfahren oder chemischen Abscheidungsverfahren aus der Gasphase mit TiN eingekapselt. Durch diese Einkapselung der Leiterbahn in TiN wird die gemäß dem Stand der Technik störende Bildung der Erhebungen, d.h. Ohren, an den Rändern des metallischen Leiters verhindert.

Die vorliegende Erfindung schafft somit ein Planarisierungsverfahren durch das Abscheiden eines Dielektrikums (SiO₂) mittels eines TEOS-Prozesses, das gegenüber bekannten Planarisierungsverfahren, die TEOS-Prozesse verwenden, eine ebenere Oberfläche der abgeschiedenen Schicht liefert. Ferner verbessert das neuartige Verfahren die lunkerfreie Auffüllung engster Zwischenräume bis in den Bereich von 10tel µm.

Weiterbildungen der vorliegenden Erfindung sind in den abhängigen Ansprüchen dargelegt.

Bevorzugte Ausführungsbeispiele der vorliegenden Erfindung werden nachfolgend bezugnehmend auf die beiliegenden Zeichnungen näher erläutert. Es zeigen:
- Fig. 1: einen Querschnitt eines bekannten Schichtaufbaus vor dem Durchführen eines bekannten Planarisierungsverfahrens;
- Fig. 2: einen Querschnitt des Schichtaufbaus von Fig. 1 nach dem Durchführen des bekannten Planarisierungsverfahrens;
- Fig. 3: einen Querschnitt eines erfindungsgemäßen Schichtaufbaus; und
- Fig. 4: den Schichtaufbau von Fig. 3 nach dem Abscheiden der SiO₂-Schicht.

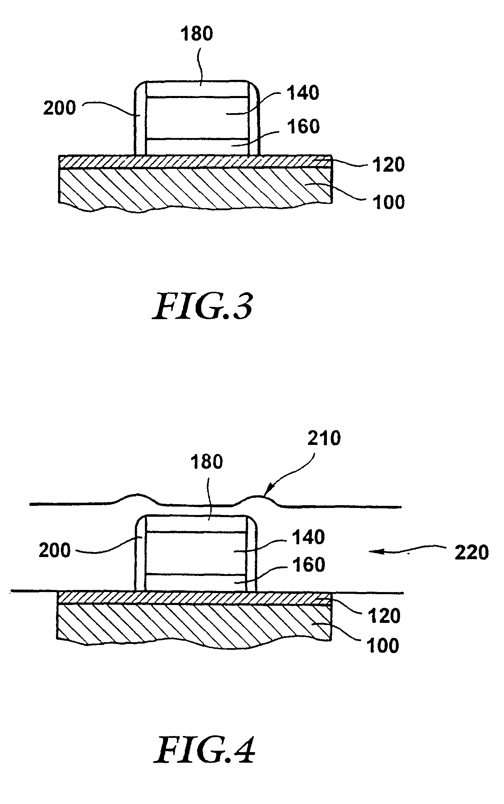

Im folgenden wird anhand der Fig. 3 und 4 das erfindungsgemäße Verfahren näher erläutert.

In Fig. 3 ist ein Substrat 100, das vorzugsweise ein Siliziumsubstrat ist, dargestellt. Bei dem bevorzugten Ausführungsbeispiel ist auf das Substrat 100 eine SiO₂-Schicht 120 aufgebracht. Ein metallischer Leiter 140 bildet eine Erhebung auf der aus dem Substrat 100 und der SiO₂-Schicht 120 gebildeten Struktur. Bei dem bevorzugten Ausführungsbeispiel ist zwischen dem metallischen Leiter 140 und der SiO₂-Schicht 120 eine Ti- oder eine TiN-Schicht 160 angeordnet. Auf der oberen Oberfläche des metallischen Leiters 140 ist eine TiN-Schicht 180 angeordnet. Bis hier entspricht der Aufbau dem in Fig. 1 dargestellten und stellt den Ausgangspunkt für das erfindungsgemäße Planarisierungsverfahren dar.

Gemäß der vorliegenden Erfindung wird nun auf den Seitenflächen des metallischen Leiters 140, d.h. der metallischen Struktur, TiN 200 abgeschieden, derart, daß die TiN-Abdeckung 180 und das auf die Seitenflächen des metallischen Leiters 140 aufgebrachte TiN den metallischen Leiter im wesentlichen einkapseln. Die Abscheidung der seitlichen TiN-Schichten 200 kann beispielsweise mittels eines PVD-Verfahrens (Physical Vapor Deposition = Sputtern) oder mittels eines chemischen Abscheidungsverfahrens aus der Gasphase (CVD-Verfahren) oder mittels eines isotropen Abscheidungsverfahrens aus der Gasphase und mittels anisotropen Rückätzens durchgeführt werden.

Nachfolgend wird ein bekannter TEOS-Prozeß durchgeführt, um eine selektive Abscheidung einer SiO₂-Schicht auf der durch das Substrat und den mit den TiN-Schichten versehenen metallischen Leiter gebildeten Oberfläche zu bewirken.

Dieser Abscheideprozeß entspricht einer ozonaktivierten SiO₂-Abscheidung mittels Tetraethylortosilikat (TEOS) bei einem Druck in der Nähe des atmosphärischen Drucks und einem vergleichsweise hohen Ozonfluß und einer hohen Ozonkonzentration. Das Einstellen der exakten Prozeßparameter, um eine selektive Abscheidung auf SiO₂ und TiN zu bewirken, ist in der Technik bekannt.

Fig. 4 zeigt die Struktur von Fig. 3 nach dem Durchführen des TEOS-Prozesses. Wie in Fig. 4 zu sehen ist, sind die an den Kanten des metallischen Leiters 140 bewirkten Erhebungen 210 der abgeschiedenen SiO₂-Schicht 220 verglichen mit den in Fig. 2 dargestellten "Ohren" 24 deutlich verringert. Die Grundlage für dieses Ergebnis ist, daß das für die seitlichen Schichten 200 verwendete Material, bei dem bevorzugten Ausführungsbeispiel TiN, eine im Vergleich zu der SiO₂-Schicht 120 geringe Abscheidungsrate induziert. Dadurch wird die Abscheidung an den Flanken, d.h. den Seitenflächen des metallischen Leiters 140, reduziert, was zu einer Reduzierung oder Beseitigung der in Fig. 2 dargestellten "Ohren" 24 führt.

Die niedrige Abscheidungsrate auf den Seitenflächen des metallischen Leiters ermöglicht des weiteren, Leiterbahnzwischenräume, d.h. Leiterbahnabstände, bis herunter zu 0,2 µm und Seitenverhältnisse (Aspektverhältnisse) von Leiterhöhe zu Leiterabstand bis zu 6 lunkerfrei aufzufüllen. Das verwendete Substrat kann beispielsweise ein beliebiges Halbleitersubstrat oder Keramiksubstrat sein, solange eine selektive Abscheidung von SiO₂ zwischen dem Substratmaterial und TiN möglich ist.

Die vorliegende Erfindung liefert somit ein Planarisierungsverfahren, das ohne zusätzliche Schritte, wie z.B. einem Rückätzen oder einem chemisch-mechanischen Polieren, eine sehr gute Einebnung einer Substratoberfläche liefert. Das einfache, erfindungsgemäße Verfahren ermöglicht somit eine Kostenreduzierung beispielsweise bei der Herstellung hochintegrierter Schaltkreise.

Bei dem beschriebenen Ausführungsbeispiel wird eine TiN-Schicht auf die Oberfläche und die Seitenflächen der metallischen Leiterstrukturen aufgebracht. Es kommt jedoch jede metallischen Titanverbindungsschicht in Betracht. Bevorzugt weist die metallische Titanverbindungsschicht TiN und/oder TiON und/oder TiW und/oder TiC und/oder TiCON auf.

Bei dem beschriebenen Ausführungsbeispiel wird ein O₃-aktiviertes Abscheiden von SiO₂ aus Tetraethylortosilikat (TEOS) auf der mit den metallischen Strukturen vorgenommen. Es können jedoch andere Siliziumvorstufen bzw. Siliziumprekursoren verwendet werden, zu denen Siliziumverbindungen mit einem der folgenden Stoffe an jeder der vier Si-Bindungen zählen: H, F, CH₃, C₂H₅, OH, OF, OCH₃, OC₂H₅.

## Patentansprüche

1. Verfahren zur Planarisierung einer Substratoberfläche, die Höhenunterschiede aufweist, die von metallischen Strukturen (140) hervorgerufen sind, mit folgenden Schritten:
Aufbringen einer metallischen Titanverbindungsschicht (180, 200) auf die Oberfläche und die Seitenflächen der metallischen Strukturen (140);
O₃-aktiviertes Abscheiden von SiO₂ oder von SiOF (220) aus einer Siliziumvorstufe auf der mit den metallischen Strukturen (140) versehenen Substratoberfläche.

2. Verfahren gemäß Anspruch 1, bei dem die metallische Titanverbindungsschicht (200) mittels Sputtern aufgebracht wird.

3. Verfahren gemäß Anspruch 1, bei dem die metallische Titanverbindungsschichtchicht (200) mittels einer chemischen Abscheidung aus der Gasphase aufgebracht wird.

4. Verfahren gemäß einem der Ansprüche 1 bis 3, bei dem das die Substratoberfläche aufweisende Substrat aus Silizium besteht.

5. Verfahren gemäß Anspruch 4, bei dem das Siliziumsubstrat eine SiO₂-Schicht (120) aufweist, auf der die metallischen Strukturen (140) angeordnet sind.

6. Verfahren gemäß einem der Ansprüche 1 bis 5, bei dem die metallischen Strukturen (140) aus Aluminium, Kupfer oder einer Legierung derselben bestehen.

7. Verfahren gemäß einem der Ansprüche 1 bis 6, bei dem das Abscheiden der SiO₂-Schicht (220) nahezu bei Atmosphärendruck und einem hohen Ozonfluß und einer hohen Ozonkonzentration erfolgt.

8. Verfahren gemäß einem der Ansprüche 1 bis 7, bei dem das O₃-aktivierte Abscheiden von SiO₂ (220) aus einer Siliziumvorstufe ein O₃-aktiviertes Abscheiden von SiO₂ aus Tetraethylortosilikat (TEOS) auf der mit den metallischen Strukturen (140) versehenen Substratoberfläche umfaßt.

9. Verfahren gemäß einem der Ansprüche 1 bis 8, bei dem die metallischen Titanverbindungsschicht (180, 200) durch chemisches Abscheiden aus der Gasphase oder durch Sputtern gebildet wird.

10. Verfahren gemäß Anspruch 9, bei dem die metallischen Titanverbindungsschicht (180, 200) aus TiN und/oder TiON und/oder TiW und/oder TiC und/oder TiCON aufweist.

11. Verfahren gemäß einem der Ansprüche 1 bis 10, bei dem die Siliziumvorstufe eine Siliziumverbindung mit einem der folgenden Stoffe an jeder der vier Si-Bindungen ist: H, F, CH₃, C₂H₅, OH, OF, OCH₃, OC₂H₅.

## Claims

1. Method for the planarization of a substrate surface which has differences in height which are caused by metallic structures (140), comprising the following steps:
applying a metallic titanium compound layer (180, 200) to the surface and the side faces of the metallic structures (140);
O₃-activated deposition of SiO₂ or of SiOF (220) from a silicon precursor on the substrate surface which is provided with the metallic structures (140).

2. Method according to Claim 1, in which the metallic titanium compound layer (200) is applied by means of sputtering.

3. Method according to Claim 1, in which the metallic titanium compound layer (200) is applied by means of chemical vapour deposition.

4. Method according to one of Claims 1 to 3, in which the substrate which has the substrate surface comprises silicon.

5. Method according to Claim 4, in which the silicon substrate has an SiO₂ layer (120) on which the metallic structures (140) are arranged.

6. Method according to one of Claims 1 to 5, in which the metallic structures (140) comprise aluminium, copper or an alloy thereof.

7. Method according to one of Claims 1 to 6, in which the deposition of the SiO₂ layer (220) takes place virtually at atmospheric pressure and with a high flow of ozone and a high concentration of ozone.

8. Method according to one of Claims 1 to 7, in which the O₃-activated deposition of SiO₂ (220) from a silicon precursor comprises an O₃-activated deposition of SiO₂ from tetraethyl orthosilicate (TEOS) on the substrate surface which is provided with the metallic structures (140).

9. Method according to one of Claims 1 to 8, in which the metallic titanium compound layer (180, 200) is formed by chemical vapour deposition or by sputtering.

10. Method according to Claim 9, in which the metallic titanium compound layer (180, 200) contains from [sic] TiN and/or TiON and/or TiW and/or TiC and/or TiCON.

11. Method according to one of Claims 1 to 10, in which the silicon precursor is a silicon compound which has one of the following substances at each of the four Si bonds: H, F, CH₃, C₂H₅, OH, OF, OCH₃, OC₂H₅.

## Revendications

1. Procédé pour rendre plane une surface de substrat qui présente des différences de niveau dues à des structures (140) métalliques, comprenant les stades suivants :
dépôt d'une couche (180, 200) métallique d'un composé du titane sur la face supérieure et les faces latérales des structures (140) métalliques ;
dépôt activé par O₃ de SiO₂ ou de SiOF (220) à partir d'un précurseur de silicium sur la surface du substrat munie des structures (140) métalliques.

2. Procédé suivant la revendication 1, dans lequel la couche (200) métallique de composé du titane est déposée par pulvérisation cathodique.

3. Procédé suivant la revendication 1, dans lequel la couche (200) métallique de composé du titane est déposée au moyen d'un dépôt chimique en phase gazeuse.

4. Procédé suivant l'une des revendications 1 à 3, dans lequel le substrat présentant la surface du substrat est en silicium.

5. Procédé suivant la revendication 4, dans lequel le substrat de silicium comprend une couche (120) en SiO₂ sur laquelle sont disposées les structures (140) métalliques.

6. Procédé suivant l'une des revendications 1 à 5, dans lequel les structures (140) métalliques sont en aluminium, en cuivre ou en l'un de leurs alliages.

7. Procédé suivant l'une des revendications 1 à 6, dans lequel le dépôt de la couche (220) de SiO₂ s'effectue pratiquement à la pression atmosphérique et sous un grand flux d'ozone et une grande concentration d'ozone.

8. Procédé suivant l'une des revendications 1 à 7, dans lequel le dépôt activé par O₃ de SiO₂ (220) à partir d'un précurseur de silicium comprend un dépôt activé par O₃ de SiO₂ à partir de tétraéthylorthosilicate (TEOS) sur la surface du substrat munie des structures (140) métalliques.

9. Procédé suivant l'une des revendications 1 à 8, dans lequel la couche (180, 200) métallique au composé de titane est formée par dépôt chimique en phase gazeuse ou par pulvérisation cathodique.

10. Procédé suivant la revendication 9, dans lequel la couche (180, 20) métallique au composé de titane comprend du TiN et/ou du TiON et/ou TiW et/ou du TiC et/ou du TiCON.

11. Procédé suivant l'une des revendications 1 à 10, dans lequel le précurseur de silicium est un composé de silicium ayant l'un des radicaux suivants à chacune des quatre liaisons Si : H, F, CH₃, C₂H₅, OH, OF, OCH₃, OC₂H₅.
